# EUROPEAN PATENT APPLICATION

(11) **EP 4 654 768 A1**
(43) Date of publication of application: **26.11.2025**
(21) Application number: 24858219.9
(22) Date of filing: 02.08.2024
(51) Int. Cl.: H05K 7/20

(54) **POWER MODULE WITH LIQUID-COOLING RADIATOR, MOTOR CONTROLLER, POWERTRAIN, AND VEHICLE**

(30) Priority: 31.08.2023 CN 202311128374
(71) Applicant: Huawei Digital Power Technologies Co., Ltd., Shenzhen, Guangdong 518043 (CN)
(72) Inventor: TANG, Tingting, Shenzhen, Guangdong 518043 (CN); LI, Jiyang, Shenzhen, Guangdong 518043 (CN); ZHANG, Weilong, Shenzhen, Guangdong 518043 (CN)
(74) Representative: Gill Jennings & Every LLP
(86) International application number: PCT/CN2024/109425
(87) International publication number: WO 2025/044676

(57) **Abstract**

This application provides a power assembly with a liquid cooling radiator, a motor control unit, a powertrain, and a vehicle. The power assembly includes a substrate, the liquid cooling radiator, and a sealing member. The substrate is configured to fasten a power switching transistor. The liquid cooling radiator includes a groove structure. The groove structure includes a bottom plate and a side plate, and the bottom plate and the substrate are spaced apart in a thickness direction of the substrate. The sealing member is configured to fasten a peripheral side surface of the substrate and an end face that is of the side plate and that faces away from the bottom plate. A material of the sealing member is different from that of the substrate. The side plate and the substrate are connected through the sealing member, so that connection stability between the substrate and the side plate is improved, and structural strength of the power assembly is enhanced. In this application, when the side plate, the sealing member, and the substrate are fastened, a mounting area for mounting another component in the substrate is not occupied, so that more components for cooling and heat dissipation are added to the power assembly, and a contact area between the substrate and a coolant is expanded, to improve cooling efficiency of the power assembly and the motor control unit.

## Description

This application claims priority to Chinese Patent Application No. 202311128374.7, filed with the China National Intellectual Property Administration on August 31, 2023 and entitled "POWER ASSEMBLY WITH LIQUID COOLING RADIATOR, MOTOR CONTROL UNIT, POWERTRAIN, AND VEHICLE", which is incorporated herein by reference in its entirety.

### TECHNICAL FIELD

This application relates to the field of motor control units, and in particular, to a power assembly with a liquid cooling radiator, a motor control unit, a powertrain, and a vehicle.

### BACKGROUND

In a powertrain of a vehicle, a motor control unit is configured to: convert, into an alternating current, a direct current input by a battery pack, and transmit the alternating current to a motor. In a working process of the motor control unit, a power assembly in the motor control unit is frequently switched between an on state and an off state, resulting in a large amount of heat generated by the motor control unit.

To implement temperature rise control on the power assembly, a heat dissipation apparatus is usually mounted, and a coolant is fed into the heat dissipation apparatus. With increase of motor power and battery pack voltage, heat generated by the motor control unit gradually increases. However, currently heat exchange performance of the heat dissipation apparatus still needs to be improved, and it is difficult to meet a heat dissipation requirement of the power assembly. Consequently, work efficiency and safety performance of the motor control unit are adversely affected.

### SUMMARY

Embodiments of this application provide a power assembly with a liquid cooling radiator, a motor control unit, a powertrain, and a vehicle that can enhance heat exchange performance and structural strength.

According to a first aspect, an embodiment of this application provides a power assembly with a liquid cooling radiator. The power assembly includes a substrate, the liquid cooling radiator, and a sealing member. The substrate is configured to fasten at least one power switching transistor. The liquid cooling radiator includes a groove structure. The groove structure includes a bottom plate and a side plate, and the bottom plate and the substrate are spaced apart in a thickness direction of the substrate. The sealing member is configured to fasten a peripheral side surface of the substrate and an end face that is of the side plate and that faces away from the bottom plate. A material of the sealing member is different from a material of the substrate.

In this embodiment of this application, there is a gap between the substrate and the bottom plate in the groove structure in the thickness direction. The groove structure is configured to feed a coolant. One function of the substrate is to fasten the power module, and another function is to transfer energy from the power module to the liquid cooling radiator.

In this embodiment of this application, the sealing member is configured to fasten the substrate and the side plate. Specifically, the sealing member is located on a peripheral side of the substrate, the thickness direction of the substrate is perpendicular to a largest surface of the substrate, an inner peripheral surface of the sealing member surrounds the thickness direction of the substrate, an outer peripheral side surface of the substrate surrounds the thickness direction of the substrate, and the inner peripheral surface of the sealing member is fastened to the outer peripheral side surface of the substrate. In this way, the sealing member does not occupy the largest surface of the substrate, and more areas are reserved for fastening a component having a heat dissipation function. For example, the component having the heat dissipation function may be a heat dissipation fin.

In this embodiment of this application, the outer peripheral side surface of the substrate is connected to the inner peripheral surface of the sealing member, so that a connection position between the outer peripheral side surface of the substrate and the inner peripheral side surface of the sealing member is on a side surface. For example, when a separation force perpendicular to the thickness direction of the substrate is applied to a part 1 that is of the sealing member and that is on one side of the substrate, the sealing member surrounds the outer peripheral side surface of the substrate, a part 2 that is of the sealing member and that is located on the other side of the substrate is opposite to the part 1, and the part 2 of the sealing member applies a reaction force to the other side of the substrate. In this way, the sealing member is not easily detached from the substrate.

In this embodiment of this application, in the thickness direction of the substrate, a surface that is of the sealing member and that faces the bottom plate is fastened to the end face that is of the side plate and that faces away from the bottom plate, so that the side plate is fastened to the substrate, and structural stability of the side plate and the substrate is improved. If the power assembly does not include the sealing member, a part of a surface that is of the substrate and that faces the bottom plate needs to be fastened to the bottom plate. For example, a fastening structure whose shape matches the substrate and the side plate is disposed on surfaces that are of the substrate and the side plate and that are opposite to each other in the thickness direction of the substrate. In this case, the fastening structure occupies a part of a surface that is of the substrate and that is configured to mount another component. When a heat dissipation fin needs to be arranged on the largest surface of the substrate, the fastening structure causes a limited quantity of heat dissipation fins on the substrate. Consequently, cooling efficiency of the coolant on the power module is adversely affected. In comparison, the sealing member in this embodiment of this application is located on the peripheral side of the substrate, and an area that is of the substrate and that is used to fasten the heat dissipation fin is larger. This further helps expand a contact area between the coolant and the substrate, and improve heat exchange performance of the power assembly.

In this embodiment of this application, the substrate and the sealing member have different main functions. The substrate is configured to implement heat transfer between the liquid cooling radiator and the power module. Therefore, the material of the substrate needs to have a good heat conduction capability. The sealing member is configured to fasten the substrate and the side plate. Therefore, the material of the sealing member needs to meet a requirement of high connection strength between the sealing member and the substrate and between the sealing member and the side plate. Generally, a material of the side plate in the liquid cooling radiator is different from the material of the substrate. When the side plate is in direct contact with and connected to the substrate, connection strength between the side plate and the substrate is low. After the side plate is connected to the sealing member, the side plate is connected to the outer peripheral side surface of the substrate through the sealing member, so that connection strength between the side plate, the sealing member, and the substrate can be comprehensively improved. In this embodiment of this application, the material of the substrate is different from the material of the sealing member, so that respective functions of the substrate and the sealing member are utilized, and heat exchange performance and structural strength of the motor control unit are considered.

In this embodiment of this application, cooling and heat dissipation are performed on the power assembly by using the coolant, to ensure that the power assembly works at an appropriate temperature. The substrate and the side plate are fastened through the sealing member on the peripheral side of the substrate, to avoid that the additional fastening structure is mounted on the largest surface of the substrate. This helps expand the mounting area of the heat dissipation fin and the contact area between the substrate and the coolant, further improve heat dissipation efficiency of the coolant, and prevent a safety accident caused by overheating of the power assembly and the motor control unit.

In an embodiment, the bottom plate includes two through holes spaced apart. Each through hole is configured to communicate between two sides of the bottom plate in the thickness direction of the substrate. A spacing distance between the two through holes is less than a length of the substrate in an arrangement direction of the two through holes. Hole diameters of the two through holes each are greater than a thickness of the side plate or the bottom plate.

In this embodiment of this application, the coolant flows into the groove structure sequentially through a through hole, and then performs heat exchange with the power switching transistor through the substrate. The spacing distance between the two through holes is less than the length of the substrate in the arrangement direction of the two through holes, so that the coolant is not easily leaked out from the through hole, thereby improving utilization of the coolant. The hole diameters of the two through holes each are greater than the thickness of the side plate or the bottom plate, so that a flow volume of the coolant can be increased, flow resistance of the coolant flowing into the groove structure can be reduced, and a loss of the coolant on a transmission path can be reduced.

In an embodiment, the substrate includes two surfaces, the two surfaces are distributed away from each other in the thickness direction of the substrate. One of the two surfaces faces away from the bottom plate, and the surface is configured to fasten the at least one power switching transistor. The other surface faces the bottom plate, and the other surface is configured to fasten a plurality of heat dissipation fins.

In this embodiment of this application, when the power switching transistor is in a working state, the power switching transistor is frequently switched between an on state and an off state, resulting in a large amount of heat generated by the power assembly. The plurality of heat dissipation fins are located in the groove structure. The heat dissipation fins and the power switching transistor are respectively located on two sides of the substrate in the thickness direction. A gap between the plurality of heat dissipation fins forms a water channel for coolant circulation. When the coolant is fed into the groove structure, the heat dissipation fin is configured to enhance turbulence of the coolant and increase a heat dissipation area. Heat generated by the power switching transistor is transferred to the heat dissipation fin through the substrate. The coolant located between the plurality of heat dissipation fins takes away the heat of the power switching transistor, to reduce a temperature of the power switching transistor in a steady working state, and controlling a temperature of the motor control unit.

In an embodiment, a difference between a melting temperature of the material of the side plate and a melting temperature of the material of the sealing member is less than 50°C, or the material of the sealing member is the same as the material of the side plate. In this embodiment of this application, the side plate and the sealing member need to be fastened. The melting temperature of the material of the side plate and the melting temperature of the material of the sealing member each are low, or the material of the sealing member is the same as the material of the side plate. This helps the side plate and the sealing member to form an integrated structure, thereby improving connection strength and sealing effect of the side plate and the sealing member.

In an embodiment, the sealing member is made of a polymer material, and the polymer material is injected on the peripheral side surface of the substrate, to form the sealing member. In this embodiment of this application, the sealing member and the peripheral side surface of the substrate are integrally formed in an injection molding manner. This helps strengthen reliability of a connection between the sealing member and the substrate.

In an embodiment, the material of the side plate is a polymer material, and the polymer material is injected on the surface that is of the sealing member and that faces the bottom plate, to form the side plate. In this embodiment of this application, both the side plate and the sealing member are made of polymer materials. This helps enhance connection stability between the side plate and the sealing member. The side plate and the sealing member may be made of a same polymer material or different polymer materials.

In an embodiment, in a direction perpendicular to the thickness direction of the substrate, a part of one of the substrate and the sealing member is embedded into the other of the substrate and the sealing member. In this embodiment of this application, the direction perpendicular to the thickness direction of the substrate is parallel to the largest surface of the substrate. A part of the substrate is embedded into the sealing member, or a part of the sealing member is embedded into the substrate. The substrate and the sealing member cooperate with each other, so that a connection relationship between the substrate and the sealing member is closer.

In an embodiment, the substrate includes one of a boss and a groove, the one of the boss and the groove surrounds the outer peripheral side surface of the substrate. The sealing member includes the other of the boss and the groove, and the other of the boss and the groove surrounds an inner peripheral side surface of the sealing member. A protrusion direction of the boss and a concave direction of the groove are the same and are both perpendicular to the thickness direction of the substrate.

In this embodiment of this application, the outer peripheral side surface of the substrate is fastened to the inner peripheral side surface of the sealing member through concave-convex matching. This helps enhance connection stability between the substrate and the sealing member. Structures of the boss and the groove are simple. The protrusion direction of the boss and the concave direction of the groove are the same and are both perpendicular to the thickness direction of the substrate. This helps reduce processing difficulty.

In an embodiment, the substrate includes the boss, the boss protrudes from the peripheral side surface of the substrate. A protrusion direction of the boss is perpendicular to the thickness direction of the substrate. The sealing member wraps the boss. Surfaces of the sealing member and the boss are connected to the peripheral side surface. In the direction perpendicular to the thickness direction of the substrate, a projection of the sealing member covers a projection of the boss.

In this embodiment of this application, the sealing member is configured to accommodate the boss. In cooperation with an injection molding process, the boss of the substrate is embedded into the sealing member. This facilitates a stable connection between the substrate and the sealing member. In this embodiment of this application, the boss is configured to increase a connection area between the substrate and the sealing member, to improve the connection stability between the substrate and the sealing member.

In an embodiment, the boss is a part of the substrate. The boss is an integrally formed part of the substrate. This embodiment of this application helps ensure structural reliability of the boss and the substrate as a whole.

In an embodiment, in the thickness direction of the substrate, a ratio of a thickness of a boss to a thickness of the substrate is greater than or equal to 0.1 and less than 1. This embodiment of this application helps reduce materials used by the substrate on the premise of meeting structural strength of the substrate.

In an embodiment, the substrate further includes a substrate body. The boss is connected to a peripheral side surface of the substrate body. The direction perpendicular to the thickness direction of the substrate includes a length direction of the substrate and a width direction of the substrate. In the length direction of the substrate, a ratio of a length of the boss to a length of the substrate body is less than 1/30. In the width direction of the substrate, a ratio of a width of the boss to a width of the substrate body is less than 1/30. The length direction of the substrate is perpendicular to the width direction of the substrate. In this embodiment of this application, on the premise of meeting the structural strength of the substrate, this helps reduce the materials used by the substrate, and can further reduce an overall volume of the motor control unit.

In an embodiment, the substrate includes the groove. The groove is concave from the peripheral side surface of the substrate. A concave direction of the groove is perpendicular to the thickness direction of the substrate. The groove is configured to accommodate a part of the sealing member. The sealing member is connected to a groove wall surface of the groove and the peripheral side surface. In the direction perpendicular to the thickness direction of the substrate, a projection of the sealing member covers a projection of the groove. In this embodiment of this application, the peripheral side surface of the substrate is connected to the groove wall surface of the groove. An opening of the groove faces the sealing member. The groove is configured to accommodate the part of the sealing member. In cooperation with an injection molding process, the sealing member is embedded into the groove of the substrate. This facilitates a stable connection between the substrate and the sealing member. In this embodiment of this application, the groove is configured to increase a connection area between the substrate and the sealing member, to improve the connection stability between the substrate and the sealing member.

In an embodiment, in the thickness direction of the substrate, a ratio of a thickness of the groove to a thickness of the substrate is greater than or equal to 0.1 and less than 1. This embodiment of this application helps reduce the materials used by the substrate on the premise of meeting the structural strength of the substrate.

In an embodiment, in the concave direction of the groove, a ratio of a length of the groove to a length of the substrate is less than 1/30. In this embodiment of this application, the ratio of the length of the groove to the length of the substrate is within a range of less than 1/30. On the premise of meeting the structural strength of the substrate, this helps reduce the materials used by the substrate, and can further reduce an overall volume of the power assembly and the motor control unit.

In an embodiment, the substrate includes a boss and a groove. The boss protrudes from the peripheral side surface of the substrate, and the groove is concave from the peripheral side surface of the substrate. A protrusion direction of the boss is opposite to a concave direction of the groove. A part of the sealing member covers the boss, and a part of the sealing member is located in the groove. In the direction perpendicular to the thickness direction of the substrate, a projection of the sealing member covers projections of the boss and the groove. In this embodiment of this application, a shape of the sealing member matches shapes of the boss and the groove, so that the sealing member can be closely connected to the substrate. The boss and the groove may be located on a same peripheral side surface of the substrate, or may be located on different peripheral side surfaces of the substrate, and may be flexibly arranged according to an actual requirement.

In an embodiment, a length of the side plate is greater than a length of the boss or the groove in a first direction. The first direction is perpendicular to the thickness direction of the substrate. The length of the side plate in the first direction is greater than a thickness of at least one of the substrate or the bottom plate. A length of the sealing member in the first direction is greater than a thickness of the substrate.

In this embodiment of this application, the first direction may be a length direction or a width direction of the largest surface of the substrate. If the length of the boss or the groove in the first direction is greater than the length of the side plate in the first direction, to ensure the structural strength of the sealing member, the length of the sealing member in the first direction needs to be greater than the length of the side plate. A contact area between the sealing member and the side plate is reduced. This may reduce connection strength between the sealing member and the side plate.

In this embodiment of this application, the length of the side plate in the first direction is greater than the thickness of at least one of the substrate or the bottom plate, and the length of the sealing member in the first direction is greater than the thickness of the substrate. This helps enhance the structural strength of the side plate and the sealing member, thereby improving stability of a connection between the substrate and the liquid cooling radiator. The thickness of the substrate and the thickness of the bottom plate are dimensions of the substrate and the bottom plate in the thickness direction.

In an embodiment, the peripheral side surface of the substrate, a surface of the boss, or a groove wall surface of the groove includes a nanopore. The nanopore is configured to accommodate a part of the sealing member. The nanopore is a hole with a hole diameter of nanometer magnitude. In this embodiment of this application, the peripheral side surface of the substrate, the surface of the boss, and the groove wall surface of the groove have nanopores and are configured to fasten the sealing member. The sealing member is made of a polymer material. The sealing member and the substrate can be fastened through nano injection molding. The peripheral side surface of the substrate, the surface of the boss, and the groove wall surface of the groove are first nano-processed, to obtain nanopores, and then a part of the sealing member is injected into the nanopores, so that the sealing member and the substrate are injected together. This increases a bonding area of the substrate and the polymer material, thereby improving connection strength of the substrate and the sealing member, and implementing compact bonding.

In an embodiment, the power assembly further includes the plurality of heat dissipation fins. A minimum distance between the heat dissipation fin and the outer peripheral side surface of the substrate is less than a sum of a fin width of the heat dissipation fin and a spacing between every two heat dissipation fins.

In this embodiment of this application, the heat dissipation fin and the power switching transistor are respectively fastened to the two surfaces that are of the substrate and that faces away from each other in the thickness direction. The heat dissipation fin is configured to increase turbulence of the coolant, increase a heat dissipation area, and improve cooling efficiency. A larger quantity of heat dissipation fins indicates higher cooling efficiency. The plurality of heat dissipation fins are arranged on the surface of the substrate at intervals, and the plurality of heat dissipation fins need to occupy a large area of the substrate. Because the substrate and the side plate do not occupy a mounting area of the substrate when being fastened, a minimum distance between the heat dissipation fin and the sealing member can be less than the sum of the column width of the heat dissipation fin and the spacing between every two heat dissipation fins. This helps fully utilize the mounting area on the substrate and increase a quantity of heat dissipation fins, so that an operating temperature of the power assembly can be controlled within an appropriate range.

In an embodiment, the power assembly includes a plurality of substrates. The plurality of substrates are spaced apart. In an arrangement direction of the plurality of substrates, a sealing member between every two adjacent substrates is configured to fasten the two adjacent substrates, and is configured to fasten two side plates on one side of the two adjacent substrates. In this embodiment of this application, the power assembly includes the plurality of substrates, so that a quantity of heat dissipation fins and a quantity of power assemblies that are connected to two sides of the substrate increase. This helps increase an area covered by heat dissipation fins, and cooling and heat dissipation can be performed on more power assemblies.

In an embodiment, the power assembly includes one substrate and a plurality of power modules. The plurality of power modules are spaced apart. A sealing member is connected to a peripheral side surface of the substrate and a surface that is of a side plate and that faces the substrate in a thickness direction. In this embodiment of this application, the plurality of power modules are fastened on one substrate. This simplifies a process and improves production efficiency.

In an embodiment, the power assembly further includes a packaging structure. The packaging structure is configured to package at least one power switching transistor, the substrate, and the sealing member. The other surface of the substrate and a surface that is of the sealing member and that faces away from the power switching transistor are both exposed outside the packaging structure.

In this embodiment of this application, the packaging structure and the power switching transistor are fastened on a same side of the substrate. The packaging structure can protect the power switching transistor from mechanical damage, chemical corrosion, and damage of another external factor. There is a connection relationship between the packaging structure and the sealing member. The other surface of the substrate and the surface that is of the sealing member and that faces away from the power switching transistor are both exposed outside the packaging structure. In this way, a projection of the packaging structure in the thickness direction of the substrate overlaps a projection of the sealing member in the thickness direction of the substrate, and the substrate and the power module are connected and fastened in the thickness direction.

In an embodiment, the power assembly further includes a partition plate, a top frame, and a plurality of flow dividing columns. The partition plate, the top frame, and the bottom plate enclose a flow dividing cavity. The plurality of flow dividing columns are located in the flow dividing cavity. The partition plate is integrally formed with the top frame and is fastened to the side plate. In the thickness direction of the substrate, two ends of each of the top frame and the flow distribution column are respectively fastened to the bottom plate and the partition plate. One end that is of the heat dissipation fin and that faces away from the substrate is fastened to the partition plate. The bottom plate, the flow distribution column, the partition plate, the heat dissipation fin, and the substrate are sequentially arranged. A distribution density of the flow distribution columns is less than a distribution density of the heat dissipation fins. The partition plate and the top frame are made of polymer materials.

In this embodiment of this application, a coolant fed into the power assembly is first dispersed by the flow distribution columns, and then flows to space between the plurality of heat dissipation fins in the groove structure. The flow distribution columns can distribute the coolant flowing to the heat dissipation fins in advance, to reduce flow resistance. The distribution density of the flow distribution columns is less than the distribution density of the heat dissipation fins, so that a loss of the coolant between the flow distribution columns is small. In addition, one end that is of the heat dissipation fin and that is away from the substrate is connected to the partition plate. This helps reduce fin top bypass of the heat dissipation fin, and improve heat exchange performance of the power assembly. Both the partition plate and the top frame are made of the polymer materials. This helps improve connection strength between the partition plate and the top frame.

According to a second aspect, an embodiment of this application provides a motor control unit. The motor control unit includes a coolant channel and the power assembly according to any one of embodiments of the first aspect. The coolant channel communicates with two through holes in a bottom plate. In this embodiment of this application, a coolant flows into a groove structure sequentially through the coolant channel and the through hole, and then performs cooling and heat dissipation on a power switching transistor through a substrate and a heat dissipation fin, to ensure that the power assembly and the motor control unit work in an appropriate temperature range.

According to a third aspect, an embodiment of this application provides a powertrain. The powertrain includes a motor and the motor control unit according to the second aspect. The motor control unit is configured to drive the motor. In this embodiment of this application, the motor control unit according to any one of embodiments of the first aspect is used in the powertrain. Because heat dissipation effect and structural strength of the motor control unit are enhanced, working efficiency and safety performance of the powertrain are improved.

According to a fourth aspect, an embodiment of this application provides a vehicle, including a vehicle body, a battery pack, and the powertrain according to the third aspect. The battery pack and the powertrain are mounted on the vehicle body. A power module in a motor control unit is configured to: convert, into an alternating current, a direct current output by the battery pack, and provide the alternating current for a motor to drive the vehicle to travel. In this embodiment of this application, the powertrain according to the second aspect is used in the vehicle. This helps improve performance of the entire vehicle.

### DESCRIPTION OF DRAWINGS

To describe technical solutions in embodiments of this application more clearly, the following describes the accompanying drawings used in embodiments of this application.
FIG. 1 is a diagram of a structure of a vehicle according to an embodiment of this application;
FIG. 2 is a diagram of a structure of a powertrain according to an embodiment of this application;
FIG. 3 is a diagram of a structure of a motor control unit according to an embodiment of this application;
FIG. 4 is a diagram of a structure of a power assembly in a motor control unit according to an embodiment of this application;
FIG. 5 is a diagram of a partial structure of a power assembly in a motor control unit according to an embodiment of this application;
FIG. 6 is a top view of a power assembly in a motor control unit according to an embodiment of this application;
FIG. 7 is a diagram of a structure of a power assembly in a motor control unit according to an embodiment of this application;
FIG. 8 is a diagram of a partial structure of a power assembly in a motor control unit according to an embodiment of this application;
FIG. 9 is a top view of a power assembly in a motor control unit according to an embodiment of this application;
FIG. 10 is a diagram of a structure of a power assembly in a motor control unit according to an embodiment of this application;
FIG. 11 is a diagram of a structure of a power assembly in a motor control unit according to an embodiment of this application;
FIG. 12 is a diagram of a structure of a power assembly in a motor control unit according to an embodiment of this application;
FIG. 13 is a diagram of a structure of a power assembly in a motor control unit according to an embodiment of this application;
FIG. 14 is a diagram of a structure of a power assembly in a motor control unit according to an embodiment of this application;
FIG. 15 is a diagram of a structure of a power assembly in a motor control unit according to an embodiment of this application;
FIG. 16 is a diagram of a structure of a power assembly in a motor control unit according to an embodiment of this application;
FIG. 17 is a diagram of a structure of a power assembly in a motor control unit according to an embodiment of this application; and
FIG. 18 is a diagram of a structure of a power assembly in a motor control unit according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In this specification, orientation terms such as "top" and "bottom" are defined relative to orientations of structures schematically placed in the accompanying drawings. It should be understood that these orientation terms are relative concepts and are used for relative description and clarification, and may correspondingly change based on a change in an orientation in which the structure is placed.

In addition, an "embodiment" or an "implementation" mentioned in this specification means that a particular feature, structure, or characteristic described with reference to this embodiment or this implementation may be included in at least one embodiment of this application. The phrase shown in various locations in this specification may not necessarily refer to a same embodiment, and is not an independent or optional embodiment exclusive from another embodiment. It is explicitly and implicitly understood by a person skilled in the art that embodiments described in this specification may be combined with another embodiment.

For ease of understanding, the following first explains and describes related technical terms in embodiments of this application.

Parallelism: The parallelism defined in embodiments of this application is not limited to absolute parallelism. A definition of the parallelism may be understood as basic parallelism, and non-absolute parallelism caused by factors such as an assembly tolerance, a design tolerance, and structural flatness is allowed.

Verticality: The verticality defined in embodiments of this application is not limited to an absolute vertical intersection (in which an included angle is 90 degrees) relationship, a non-absolute vertical intersection relationship caused by factors such as an assembly tolerance, a design tolerance, and structural flatness is allowed, and an error within a small angle range is allowed. For example, a relationship within an assembly error range of 80 degrees to 100 degrees may be understood as a vertical relationship.

An existing power assembly has a problem of low heat exchange efficiency. An embodiment of this application provides a power assembly with a liquid cooling radiator. The power assembly includes a substrate, the liquid cooling radiator, and a sealing member. The substrate is configured to fasten at least one power switching transistor, the power switching transistor is configured to implement alternating current/direct current conversion, and the liquid cooling radiator is configured to feed a coolant. The liquid cooling radiator includes a groove structure. The groove structure includes a bottom plate and a side plate. The groove structure is configured to accommodate a component such as a heat dissipation fin. The bottom plate and the substrate are spaced apart in a thickness direction of the substrate. The sealing member is configured to fasten a peripheral side surface of the substrate and an end face that is of the side plate and that faces away from the bottom plate, so that a surface that is of the substrate and that faces the bottom plate has more areas for fastening another component, for example, a heat dissipation fin. A material of the sealing member is different from a material of the substrate. The side plate and the substrate are connected through the sealing member, so that connection stability between the substrate and the side plate is improved, and structural strength of the power assembly is enhanced. In this embodiment of this application, when the side plate, the sealing member, and the substrate are fastened, a mounting area for mounting another component in the substrate is not occupied, so that more components for cooling and heat dissipation are added to the power assembly, and a contact area between the substrate and the coolant is expanded, to improve cooling efficiency of the power assembly and a motor control unit.

The power assembly provided in this embodiment of this application can be used in the motor control unit, and the motor control unit including the power assembly in this embodiment of this application can be used in a powertrain and a vehicle.

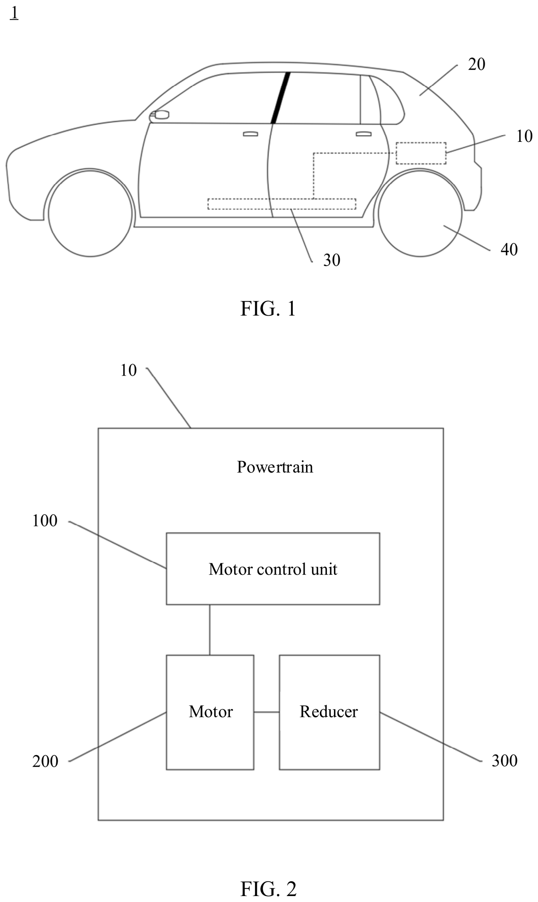

Refer to FIG. 1. FIG. 1 is a diagram of a structure of a vehicle 1 according to an embodiment of this application. In an embodiment, the vehicle 1 includes a vehicle body 20, a battery pack 30, and a powertrain 10. The battery pack 30 and the powertrain 10 are mounted on the vehicle body 20. The powertrain 10 is configured to convert electric energy output by the battery pack 30 into mechanical energy, to drive the vehicle 1 to travel. The vehicle 1 is a wheeled device driven or pulled by a power apparatus.

Refer to FIG. 2. FIG. 2 is a diagram of a structure of the powertrain 10 according to an embodiment of this application. In an embodiment, the powertrain 10 includes a motor control unit 100, a motor 200, and a reducer 300. The motor control unit 100 is separately electrically connected to the battery pack 30 and the motor 200. The motor control unit 100 receives a direct current output by the battery pack 30, converts the direct current into an alternating current, and transmits the alternating current to the motor 200. The motor 200 is fastened to the reducer 300. The motor 200 converts electric energy into mechanical energy, and further transfers the mechanical energy to the reducer 300. In an embodiment, the vehicle 1 further includes a wheel 40. The reducer 300 is fastened to the wheel 40, and the reducer 300 is configured to drive the wheel 40 to rotate.

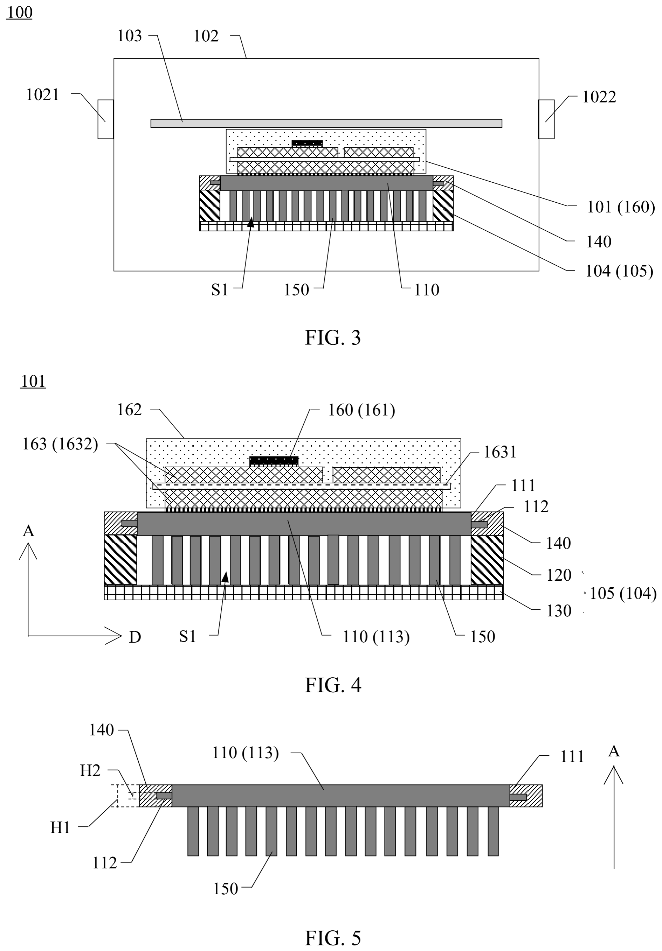

Refer to FIG. 3. FIG. 3 is a diagram of a structure of the motor control unit 100 according to an embodiment of this application. In an embodiment, the motor control unit 100 includes a housing 102, a circuit board 103, and a power assembly 101. The housing 102 is configured to accommodate the circuit board 103 and the power assembly 101. The circuit board 103 is electrically connected to the power assembly 101. The housing 102 includes a direct current input interface 1021 and an alternating current output interface 1022. The power assembly 101 is electrically connected between the direct current input interface 1021 and the alternating current output interface 1022. The motor control unit 100 is electrically connected to the battery pack 30 through the direct current input interface 1021 (not shown in the figure), and is electrically connected to the motor 200 through the alternating current output interface 1022 (not shown in the figure). A power module 160 in the power assembly 101 is configured to convert an alternating current into a direct current.

In an embodiment, the motor control unit 100 further includes a bus capacitor. The bus capacitor is connected between the direct current input interface 1021 and the power assembly 101. In an embodiment, the motor control unit 100 further includes a coolant channel. The coolant channel is configured to feed cooling water into a water channel in the power assembly 101. It should be noted that FIG. 3 shows the power assembly 101 and the circuit board 103 in the motor control unit 100, but does not represent an actual position relationship between the circuit board 103 and the power assembly 101. The power assembly 101 and the circuit board 103 may be specifically arranged according to a requirement.

In the motor control unit, the power assembly is configured to implement conversion between a direct current and an alternating current. The power assembly generates heat in a working process, and high heat greatly affects running efficiency of the power assembly. To control a temperature of the power assembly within an appropriate range, a coolant may be fed into the power assembly. However, currently, it is difficult to match heat dissipation effect of the power assembly with a heat amount.

In embodiments of this application, the power assembly is improved, so that the heat dissipation effect of the power assembly can be enhanced, and it can be ensured that the power assembly works in the appropriate temperature range.

The following describes in detail the power assembly provided in embodiments of this application.

Refer to FIG. 4. FIG. 4 is a diagram of a structure of the power assembly 101 in the motor control unit 100 according to an embodiment of this application. In an embodiment, the power assembly 101 includes a substrate 110, a liquid cooling radiator, and a sealing member 140. The substrate 110 is configured to fasten at least one power switching transistor 161. The liquid cooling radiator 104 includes a groove structure 105. The groove structure 105 includes a bottom plate 130 and a side plate 120. The bottom plate 130 and the substrate 110 are spaced apart in a thickness direction A of the substrate 110. The sealing member 140 is configured to fasten a peripheral side surface of the substrate 110 and an end face that is of the side plate 120 and that faces away from the bottom plate. A material of the sealing member 140 is different from a material of the substrate 110.

In this embodiment of this application, there is a gap between the substrate 110 and the bottom plate 130 in the groove structure 105 in the thickness direction A. The substrate 110 and the groove structure 105 jointly enclose an accommodating cavity S1. The accommodating cavity S1 is configured to feed a coolant. One of functions of the substrate 110 is to fasten the power module 160, and another function is to transfer energy from the power module 160 to the liquid cooling radiator 104.

In this embodiment of this application, the sealing member 140 is configured to fasten the substrate 110 and the side plate 120. Specifically, the sealing member 140 is located on a peripheral side of the substrate 110, the thickness direction A of the substrate 110 is perpendicular to a largest surface of the substrate 110, an inner peripheral surface of the sealing member 140 surrounds the thickness direction A of the substrate 110, an outer peripheral side surface of the substrate 110 surrounds the thickness direction A of the substrate 110, and the inner peripheral surface of the sealing member 140 is fastened to the outer peripheral side surface of the substrate 110. In this way, the sealing member 140 does not occupy the largest surface of the substrate 110, and more areas are reserved for fastening a component having a heat dissipation function. For example, the component having the heat dissipation function may be a heat dissipation fin.

In this embodiment of this application, the outer peripheral side surface of the substrate 110 is connected to the inner peripheral surface of the sealing member 140, so that a connection position between the outer peripheral side surface of the substrate 110 and the inner peripheral surface of the sealing member 140 is on a side surface. For example, when a separation force perpendicular to the thickness direction of the substrate 110 is applied to a part 1 that is of the sealing member 140 and that is on one side of the substrate 110, the sealing member 140 surrounds the outer peripheral side surface of the substrate 110, a part 2 that is of the sealing member 140 and that is located on the other side of the substrate 110 is opposite to the part 1, and the part 2 of the sealing member 140 applies a reaction force to the other side of the substrate 110. In this way, the sealing member 140 is not easily detached from the substrate 110.

In this embodiment of this application, in the thickness direction A of the substrate 110, a surface that is of the sealing member 140 and that faces the bottom plate 130 is fastened to the end face that is of the side plate 120 and that faces away from the bottom plate 130, so that the side plate 120 is fastened to the substrate 110, and structural stability of the side plate 120 and the substrate 110 is improved. If the power assembly 101 does not include the sealing member 140, a part of a surface that is of the substrate 110 and that faces the bottom plate 130 needs to be fastened to the bottom plate 130. For example, a fastening structure whose shape matches the substrate 110 and the side plate 120 is disposed on surfaces that are of the substrate 110 and the side plate 120 and that are opposite to each other in the thickness direction A of the substrate 110. In this case, the fastening structure occupies a part of a surface that is of the substrate 110 and that is configured to mount another component. When a heat dissipation fin needs to be arranged on the largest surface of the substrate 110, the fastening structure causes a limited quantity of heat dissipation fins on the substrate 110. Consequently, cooling efficiency of the coolant on the power module 160 is adversely affected. In comparison, the sealing member 140 in this embodiment of this application is located on the peripheral side of the substrate 110, and an area that is of the substrate 110 and that is used to fasten the heat dissipation fin is larger. This further helps expand a contact area between the coolant and the substrate, and improve heat exchange performance of the power assembly 101.

In this embodiment of this application, the substrate 110 and the sealing member 140 have different main functions. The substrate 110 is configured to implement heat transfer between the liquid cooling radiator 104 and the power module 160. Therefore, the material of the substrate 110 needs to have a good heat conduction capability. For example, the substrate 110 is made of a metal material. The sealing member 140 is configured to fasten the substrate 110 and the side plate 120. Therefore, the material of the sealing member 140 needs to meet a requirement of high connection strength between the sealing member 140 and the substrate 110 and between the sealing member 140 and the side plate 120. For example, the material of the sealing member 140 is the same as a material of the side plate 120. This helps enhance hot-pressed connection strength between the sealing member 140 and the side plate 120. Generally, the material of the side plate 120 in the liquid cooling radiator 104 is different from the material of the substrate 110. When the side plate 120 is in direct contact with and connected to the substrate 110, connection strength between the side plate 120 and the substrate 110 is low. After the side plate 120 is connected to the sealing member 140, the side plate 120 is connected to the outer peripheral side surface of the substrate 110 through the sealing member 140, so that connection strength between the side plate 120, the sealing member 140, and the substrate 110 can be comprehensively improved. In this embodiment of this application, the material of the substrate 110 is different from the material of the sealing member 140, so that respective functions of the substrate 110 and the sealing member 140 are utilized, and heat exchange performance and structural strength of the motor control unit 100 are considered.

In this embodiment of this application, cooling and heat dissipation are performed on the power assembly 101 by using the coolant, to ensure that the power assembly 101 works at an appropriate temperature. The substrate 110 and the side plate 120 are fastened through the sealing member 140 on the peripheral side of the substrate 110, to avoid that the additional fastening structure is mounted on the largest surface of the substrate 110. This helps expand the mounting area of the heat dissipation fin and the contact area between the substrate 110 and the coolant, further improve heat dissipation efficiency of the coolant, and prevent a safety accident caused by overheating of the power assembly 101 and the motor control unit 100.

It should be noted that, in this embodiment of this application, the coolant is nonconductive pure water. In some other embodiments, the coolant may be any one of the following: a fluoride, methyl silicone oil, silicone oil, or mineral oil. A person skilled in the art may select a type of a cooling medium according to an actual requirement. This is not limited in this embodiment of this application.

In an embodiment, the bottom plate 130 includes two through holes (not shown in the figure) spaced apart. Each through hole is configured to communicate between two sides of the bottom plate 130 in the thickness direction A of the substrate 110. A spacing distance between the two through holes is less than a length of the substrate 110 in an arrangement direction of the two through holes. Hole diameters of the two through holes each are greater than a thickness of the side plate 120 or the bottom plate 130.

In this embodiment of this application, the through hole is configured to communicate with the coolant channel of the motor control unit 100. The coolant flows into the groove structure 105 sequentially through the coolant channel and the through hole, and then performs heat exchange with the power switching transistor 161 through the substrate 110. The spacing distance between the two through holes is less than the length of the substrate 110 in the arrangement direction of the two through holes, so that the coolant is not easily leaked out from the through hole, thereby improving utilization of the coolant. The hole diameters of the two through holes each are greater than the thickness of the side plate 120 or the bottom plate 130, so that a flow volume of the coolant can be increased, flow resistance of the coolant flowing into the groove structure 105 can be reduced, and a loss of the coolant on a transmission path can be reduced.

Still refer to FIG. 4. In an embodiment, the substrate 110 includes two surfaces, the two surfaces are distributed away from each other in the thickness direction A of the substrate 110. One of the two surfaces faces away from the bottom plate 130, and the surface is configured to fasten the at least one power switching transistor 161. The other surface faces the bottom plate 130, and the other surface is configured to fasten a plurality of heat dissipation fins 150.

The power switching transistor 161 is a combination of power electronic components capable of implementing a power conversion function. The power electronic component includes at least one of the following: an insulated gate bipolar transistor (Insulated Gate Bipolar Transistor, IGBT), a silicon carbide power tube, a silicon tube, a metal-oxide semiconductor field-effect transistor (Metal-Oxide-Semiconductor Field-Effect Transistor, MOSFET), and a diode.

In this embodiment of this application, one or more power switching transistors 161 form the power module 160. When the power module 160 is in a working state, the power switching transistor 161 is frequently switched between an on state and an off state, resulting in a large amount of heat generated by the power assembly 101. The plurality of heat dissipation fins 150 are located in the accommodating cavity S1. The heat dissipation fins 150 and the power module 160 are respectively located on two sides of the substrate 110 in the thickness direction A. A gap between the plurality of heat dissipation fins 150 forms a water channel for coolant circulation. When the coolant is fed into the accommodating cavity S1, the heat dissipation fin 150 is configured to enhance turbulence of the coolant and increase a heat dissipation area. Heat generated by the power module 160 is transferred to the heat dissipation fin 150 through the substrate 110. The coolant located between the plurality of heat dissipation fins 150 takes away the heat of the power module 160, to reduce a temperature of the power module 160 in a stable working state, and control a temperature of the motor control unit 100.

In an embodiment, a difference between a melting temperature of the material of the side plate 120 and a melting temperature of the material of the sealing member 140 is less than 50°C, or the material of the sealing member 140 is the same as the material of the side plate 120. In this embodiment of this application, the side plate 120 and the sealing member 140 need to be fastened. The melting temperature of the material of the side plate 120 and the melting temperature of the material of the sealing member 140 each are low, or the material of the sealing member 140 is the same as the material of the side plate 120. This helps the side plate 120 and the sealing member 140 to form an integrated structure, thereby improving connection strength and sealing effect of the side plate 120 and the sealing member 140. A method for forming the integrated structure may be a welding manner without solder paste, for example, hot-press bonding sealing welding, hot melt welding, ultrasonic welding, or super-cycle welding, or a welding manner using another third material.

In an embodiment, the sealing member 140 is made of a polymer material, and the polymer material is injected on the peripheral side surface 111 of the substrate 110, to form the sealing member 140. In this embodiment of this application, the sealing member 140 and the peripheral side surface 111 of the substrate 110 are integrally formed in an injection molding manner. This helps strengthen reliability of a connection between the sealing member 140 and the substrate 110.

In an embodiment, the material of the side plate 120 is a polymer material, and the polymer material is injected on the surface that is of the sealing member 140 and that faces the bottom plate 130, to form the side plate 120. In this embodiment of this application, both the side plate 120 and the sealing member 140 are made of polymer materials. This helps enhance connection stability between the side plate 120 and the sealing member 140. The side plate 120 and the sealing member 140 may be made of a same polymer material or different polymer materials. In an embodiment, the side plate 120 and the sealing member 140 may be fastened in a manner of laser welding or adhesive bonding.

In an embodiment, the polymer material of the side plate 120 or the sealing member 140 can bear a temperature greater than or equal to 200 degrees Celsius, so that when the power module 160 works and heats up, the side plate 120 does not melt and is separated from the sealing member 140, thereby ensuring the reliability of the connection between the side plate 120 and the sealing member 140. In an embodiment, the side plate 120 or the sealing member 140 can bear pressure greater than or equal to 10 megapascals, and is not prone to chemical reaction with the coolant. For example, the polymer material in this embodiment of this application may be polyphthalamide (PPA), polyphenylene sulfone resin (PPSU), polyetheretherketone (PEEK), or the like. For example, the material of the substrate 110 is aluminum, copper, or the like. For example, the polymer material in this embodiment of this application may alternatively be another polymer material that can implement a nano-scale high-strength connection to the substrate 110.

Still refer to FIG. 4. In an embodiment, in a direction perpendicular to the thickness direction A of the substrate 110, a part of one of the substrate 110 and the sealing member 140 is embedded into the other of the substrate 110 and the sealing member 140. In this embodiment of this application, the direction perpendicular to the thickness direction A of the substrate 110 is parallel to the largest surface of the substrate 110. A part of the substrate 110 is embedded into the sealing member 140, or a part of the sealing member 140 is embedded into the substrate 110. The substrate 110 and the sealing member 140 cooperate with each other, so that a connection relationship between the substrate 110 and the sealing member 140 is closer.

In an embodiment, the direction perpendicular to the thickness direction A of the substrate 110 includes a left-right direction in FIG. 4 and a direction perpendicular to a paper plane in FIG. 4. For example, the direction perpendicular to the thickness direction A of the substrate 110 includes a length direction and a width direction of the substrate 110. In an embodiment, in the length direction of the substrate 110, a part of one of the substrate 110 and the sealing member 140 is embedded into the other of the substrate 110 and the sealing member 140. In an embodiment, in the width direction of the substrate 110, a part of one of the substrate 110 and the sealing member 140 is embedded into the other of the substrate 110 and the sealing member 140.

In an embodiment, the substrate 110 includes one of a boss 112 and a groove 114, the one of the boss 112 and the groove 114 surrounds the outer peripheral side surface of the substrate 110. The sealing member 140 includes the other of the boss 112 and the groove 114, and the other of the boss 112 and the groove 114 surrounds an inner peripheral side surface of the sealing member 140. A protrusion direction of the boss 112 and a concave direction of the groove 114 are the same and are both perpendicular to the thickness direction A of the substrate 110. In this embodiment of this application, the outer peripheral side surface of the substrate 110 is fastened to the inner peripheral side surface of the sealing member 140 through concave-convex matching. This helps enhance connection stability between the substrate 110 and the sealing member 140. The protrusion direction of the boss 112 and the concave direction of the groove 114 are the same and are both perpendicular to the thickness direction A of the substrate 110. This helps reduce processing difficulty.

The following specifically describes an embodiment in which the substrate 110 includes a boss 112. Still refer to FIG. 4. In an embodiment, the substrate 110 includes the boss 112, the boss 112 protrudes from the peripheral side surface 111 of the substrate 110. A protrusion direction of the boss 112 is perpendicular to the thickness direction A of the substrate 110. The sealing member 140 wraps the boss 112. The sealing member 140 is connected to a surface of the boss 112 and the peripheral side surface 111. In the direction perpendicular to the thickness direction A of the substrate 110, a projection of the sealing member 140 covers a projection of the boss 112.

In this embodiment of this application, the sealing member 140 is configured to accommodate the boss 112. In cooperation with an injection molding process, the boss 112 of the substrate 110 is embedded into the sealing member 140. This facilitates a stable connection between the substrate 110 and the sealing member 140. In this embodiment of this application, the boss 112 is configured to increase a connection area between the substrate 110 and the sealing member 140, to improve the connection stability between the substrate 110 and the sealing member 140.

It should be noted that, in this embodiment of this application, a projection in the direction perpendicular to the thickness direction A of the substrate 110 is a projection that is in the direction perpendicular to the thickness direction A of the substrate 110 and that is on a projection surface parallel to the thickness direction A of the substrate 110. The projection surface of the projection in the direction perpendicular to the thickness direction A of the substrate 110 is perpendicular to the thickness direction A of the substrate 110.

In this embodiment of this application, the boss 112 surrounds the peripheral side surface of the substrate 110. For example, bosses 112 are fastened to side surfaces that are of the substrate 110 and that are arranged opposite to each other in the length direction, and bosses 112 are fastened to side surfaces that are of the substrate 110 and that are arranged opposite to each other in the width direction.

In an embodiment, the boss 112 is a part of the substrate 110. The boss 112 is an integrally formed part of the substrate 110, to ensure structural reliability of the boss 112 and the substrate 110 as a whole.

Refer to FIG. 5. FIG. 5 is a diagram of a partial structure of the power assembly 101 in the motor control unit 100 according to an embodiment of this application. In an embodiment, in the thickness direction A of the substrate 110, a ratio of a thickness of a boss 112 to a thickness of the substrate 110 is greater than or equal to 0.1 and less than 1. In this embodiment of this application, the thickness of the substrate 110 is denoted as H1, the thickness of the boss 112 is denoted as H2, and a ratio of H2 to H1 is within a range of 0.1 to 1. This helps reduce materials used by the substrate 110 on the premise of meeting structural strength of the substrate 110.

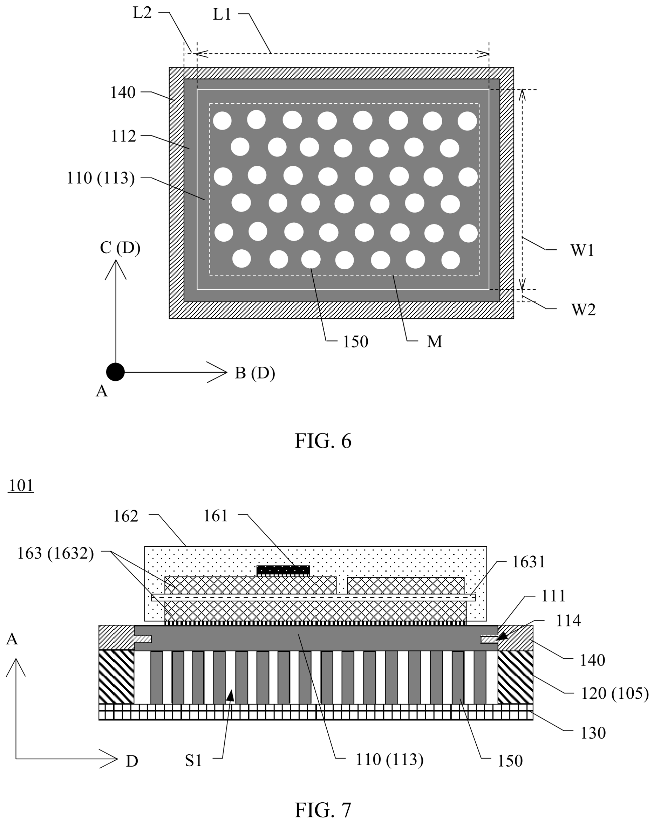

Refer to FIG. 6. FIG. 6 is a top view of the power assembly 101 in the motor control unit 100 according to an embodiment of this application. In an embodiment, the substrate 110 further includes a substrate body 113. The boss 112 is connected to a peripheral side surface of the substrate body 113. The direction perpendicular to the thickness direction A of the substrate 110 includes a length direction B of the substrate 110 and a width direction C of the substrate 110. In the length direction B of the substrate 110, a ratio of a length of the boss 112 to a length of the substrate body 113 is less than 1/30. In the width direction C of the substrate 110, a ratio of a width of the boss 112 to a width of the substrate body 113 is less than 1/30. The length direction B of the substrate 110 is perpendicular to the width direction C of the substrate 110. In this embodiment of this application, the length of the substrate body is denoted as L1, the length of the boss is denoted as L2, the width of the substrate body is denoted as W1, and the width of the boss is denoted as W2. A ratio of L2 to L1 and a ratio of W2 to W1 each are less than 1/30. On the premise of meeting the structural strength of the substrate 110, this helps reduce the materials used by the substrate 110, and can further reduce an overall volume of the motor control unit 100.

The following specifically describes an embodiment in which the substrate 110 includes a groove 114. Refer to FIG. 7. FIG. 7 is a diagram of a structure of a power assembly 101 in the motor control unit 100 according to an embodiment of this application. In an embodiment, the substrate 110 includes the groove 114. The groove 114 is concave from the peripheral side surface 111 of the substrate 110. A concave direction of the groove 114 is perpendicular to the thickness direction A of the substrate 110. The groove 114 is configured to accommodate a part of the sealing member 140. The sealing member 140 is connected to a groove wall surface of the groove 114 and the peripheral side surface 111. In the direction perpendicular to the thickness direction A of the substrate 110, a projection of the sealing member 140 covers a projection of the groove 114. In this embodiment of this application, the peripheral side surface 111 of the substrate 110 is connected to the groove wall surface of the groove 114. An opening of the groove 114 faces the sealing member 140. The groove 114 is configured to accommodate the part of the sealing member 140. In cooperation with an injection molding process, the sealing member 140 is embedded into the groove 114 of the substrate 110. This facilitates a stable connection between the substrate 110 and the sealing member 140. In this embodiment of this application, the groove 114 is configured to increase a connection area between the substrate 110 and the sealing member 140, to improve the connection stability between the substrate 110 and the sealing member 140.

In this embodiment of this application, the groove 114 surrounds the peripheral side surface of the substrate 110. For example, side surfaces that are of the substrate 110 and that are arranged opposite to each other in the length direction have grooves 114, and side surfaces that are of the substrate 110 that are arranged opposite to each other in the width direction have grooves 114.

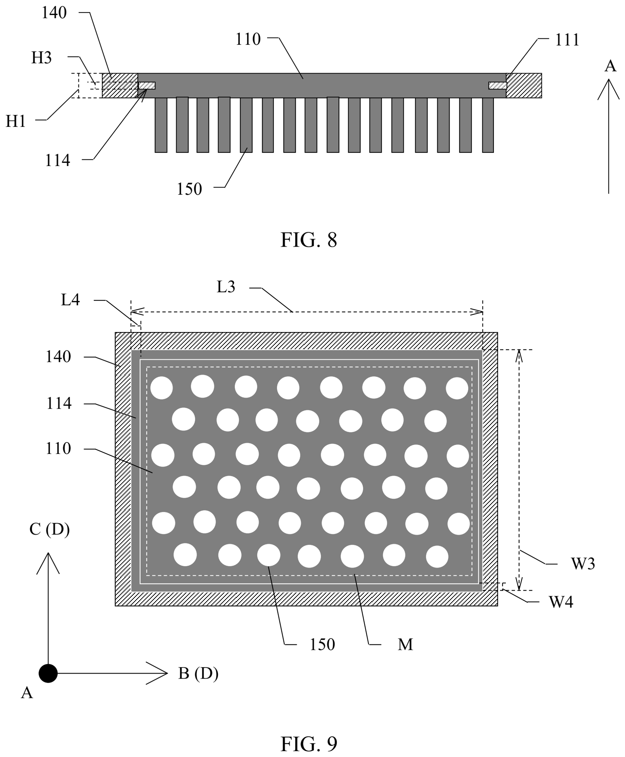

Refer to FIG. 8. FIG. 8 is a diagram of a partial structure of the power assembly 101 in the motor control unit 100 according to an embodiment of this application. In an embodiment, in the thickness direction A of the substrate 110, a ratio of a thickness of the groove 114 to a thickness of the substrate 110 is greater than or equal to 0.1 and less than 1. In this embodiment of this application, the groove wall surface of the groove 114 includes two side walls that are arranged opposite to each other in the thickness direction A of the substrate 110. The thickness of the groove 114 is a distance between the two side walls in the thickness direction A of the substrate 110. The thickness of the groove 114 is denoted as H3, the thickness of the substrate 110 is H1, and a ratio of H3 to H1 is within a range of 0.1 to 1. This helps reduce materials used by the substrate 110 on the premise of meeting structural strength of the substrate 110.

Refer to FIG. 9. FIG. 9 is a top view of the power assembly 101 in the motor control unit 100 according to an embodiment of this application. In an embodiment, in the concave direction of the groove 114, a ratio of a length of the groove 114 to a length of the substrate 110 is less than 1/30. In this embodiment of this application, the ratio of the length of the groove 114 to the length of the substrate 110 is within a range of less than 1/30. On the premise of meeting the structural strength of the substrate 110, this helps reduce the materials used by the substrate 110, and can further reduce an overall volume of the power assembly 101 and the motor control unit 100. In an embodiment, when the groove 114 is concave in a length direction B of the substrate 110, in the length direction B of the substrate 110, a ratio L4:L3 of a length of the groove 114 to a length of the substrate 110 is less than 1/30. When the groove 114 is concave in a width direction C of the substrate 110, in the width direction C of the substrate 110, a ratio W4:W3 of a width of the groove 114 to a width of the substrate 110 is less than 1/30.

In an embodiment, the substrate 110 includes a boss 112 and a groove 114. The boss 112 protrudes from the peripheral side surface 111 of the substrate 110, and the groove 114 is concave from the peripheral side surface 111 of the substrate 110. A protrusion direction of the boss 112 is opposite to a concave direction of the groove 114. A part of the sealing member 140 covers the boss 112, and a part of the sealing member 140 is located in the groove 114. In the direction perpendicular to the thickness direction A of the substrate 110, a projection of the sealing member 140 covers projections of the boss 112 and the groove 114. In this embodiment of this application, a shape of the sealing member 140 matches shapes of the boss 112 and the groove 114, so that the sealing member 140 can be closely connected to the substrate 110. The boss 112 and the groove 114 may be located on a same peripheral side surface 111 of the substrate 110, or may be located on different peripheral side surfaces 111 of the substrate 110, and may be flexibly arranged according to an actual requirement.

For example, side surfaces that are of the substrate 110 and that are arranged opposite to each other in the width direction include bosses 112, and side surfaces that are of the substrate 110 and that are arranged opposite to each other in the length direction include grooves 114. For example, side surfaces that are of the substrate 110 and that are arranged opposite to each other in the length direction include bosses 112, and side surfaces that are of the substrate 110 and that are arranged opposite to each other in the width direction include grooves 114.

For example, side surfaces that are of the substrate 110 and that are arranged opposite to each other in the width direction each include the boss 112 and the groove 114. The boss 112 and the groove 114 are arranged in the thickness direction A, to increase a connection area between a side surface of the substrate 110 and the sealing member 140, and improve structural strength of the substrate 110 and the sealing member 140.

In an embodiment, the boss 112 or the groove 114 may be discontiguous in a direction surrounding the peripheral side surface of the substrate 110. For example, the boss 112 includes a plurality of sub bosses spaced apart, the groove 114 includes a plurality of sub grooves spaced apart, and the sub bosses are located in the sub grooves, so that the sealing member 140 is connected to the peripheral side surface of the substrate 110.

Still refer to FIG. 4 and FIG. 7. In an embodiment, in a first direction D, a length of the side plate 120 is greater than a length of the boss 112 or the groove 114. The first direction D is perpendicular to the thickness direction A of the substrate 110. The length of the side plate 120 in the first direction D is greater than a thickness of at least one of the substrate 110 or the bottom plate 130. A length of the sealing member 140 in the first direction D is greater than the thickness of the substrate 110.

In this embodiment of this application, the first direction D may be a length direction B or a width direction C of a largest surface of the substrate 110. If the length of the boss 112 or the groove 114 in the first direction D is greater than the length of the side plate 120 in the first direction D, to ensure the structural strength of the sealing member 140, the length of the sealing member 140 in the first direction D needs to be greater than the length of the side plate 120. A contact area between the sealing member 140 and the side plate 120 is reduced. This may reduce connection strength between the sealing member 140 and the side plate 120.

In this embodiment of this application, the length of the side plate 120 in the first direction D is greater than the thickness of at least one of the substrate 110 or the bottom plate 130, and the length of the sealing member 140 in the first direction D is greater than the thickness of the substrate 110. This helps enhance the structural strength of the side plate 120 and the sealing member 140, thereby improving stability of a connection between the substrate 110 and the liquid cooling radiator 104. The thickness of the substrate 110 and the thickness of the bottom plate 130 are dimensions of the substrate 110 and the bottom plate 130 in the thickness direction A.

In an embodiment, the peripheral side surface of the substrate 110, a surface of the boss 112, or a groove wall surface of the groove 114 includes a nanopore (not shown in the figure). The nanopore is configured to accommodate a part of the sealing member 140. The nanopore is a hole with a hole diameter of nanometer magnitude. In this embodiment of this application, the peripheral side surface 111 of the substrate 110, the surface of the boss 112, and the groove wall surface of the groove 114 have nanopores and are configured to fasten the sealing member 140. The sealing member 140 is made of a polymer material. The sealing member 140 and the substrate 110 can be fastened through nano injection molding. For example, the peripheral side surface 111 of the substrate 110, the surface of the boss 112, and the groove wall surface of the groove 114 are first nano-processed, to obtain nanopores, and then a part of the sealing member 140 is injected into the nanopores, so that the sealing member 140 and the substrate 110 are injected together. This increases a bonding area of the substrate 110 and the polymer material, thereby improving connection strength of the substrate 110 and the sealing member 140, and implementing compact bonding.

For example, nanopores on a surface of the substrate 110 may be implemented by using a T treatment technology or an E treatment technology. The T treatment technology includes the following steps in sequence: water washing, alkali washing, water washing, acid washing, water washing, eight times of T treatment, water washing, and drying. The alkali washing is to immerse the substrate in alkaline liquid of 20 g/L to 100 g/L for 30 seconds to 60 seconds, to remove impurities such as surface grease. The acid cleaning is to immerse the substrate in acid liquid of 100 g/L to 200 g/L for 40 seconds to 90 seconds, to form preliminary holes. The eight times of T treatment are to sequentially immerse the substrate in each of eight T liquid treatment tanks for about 3 minutes, so that the holes obtained through acid treatment further form nanopores. The water washing is to clean liquid left on the surface of the substrate in a previous step with pure water. The E treatment technology includes the following steps in sequence: water washing, alkali washing, water washing, acid washing, water washing, pre-oxidation, water washing, four times of E treatment, water washing, and drying. A difference between the E treatment and the T treatment lies in that the E treatment adds the pre-oxidation treatment and replaces the eight times of T treatment with the four times of E treatment. The pre-oxidation treatment is to oxidize the substrate for 5 minutes to 10 minutes by using a sulfuric acid oxidation method (H₂SO₄ concentration is 150 g/L to 180 g/L, and Al ion concentration is 5 g/L to 15 g/L). The four times of E treatment are to sequentially immerse the substrate in each of four E liquid treatment tanks for 0.5 minute to 2 minutes.

Still refer to FIG. 4. In an embodiment, in the thickness direction A of the substrate 110, a projection of the side plate 120 partially overlaps both a projection of the boss 112 and a projection of the sealing member 140. In this embodiment of this application, the side plate 120, the substrate 110, and the sealing member 140 are arranged in a regular manner, so that the sealing member 140 fastens the side plate 120 and the substrate 110. The side plate 120, the substrate 110, and the sealing member 140 overlap in the thickness direction A of the substrate 110. When the side plate 120 is detached from the sealing member 140, an action force in the thickness direction A needs to be applied to the side plate 120. The side plate 120 generates an action force in the thickness direction A on the sealing member 140, and an overlapping part of the boss 112 and the sealing member 140 in the thickness direction A has a reaction force on the sealing member 140, so that the sealing member 140 and the substrate 110 have a stable structure.

In an embodiment, in the thickness direction A of the substrate 110, a projection of the side plate 120 completely overlaps a projection of the sealing member 140, so that a connection area between the side plate 120 and the sealing member 140 is larger, thereby ensuring connection stability.

Still refer to FIG. 4, FIG. 6, and FIG. 9. In an embodiment, the power assembly 101 further includes the plurality of heat dissipation fins 150. A minimum distance between the heat dissipation fin 150 and the outer peripheral side surface of the substrate 110 is less than a sum of a fin width of the heat dissipation fin 150 and a spacing between every two heat dissipation fins 150.

In this embodiment of this application, the heat dissipation fin 150 and the power switching transistor 161 are respectively fastened to the two surfaces that are of the substrate 110 and that faces away from each other in the thickness direction A. The heat dissipation fin 150 is configured to increase turbulence of the coolant, increase a heat dissipation area, and improve cooling efficiency. A larger quantity of heat dissipation fins 150 indicates higher cooling efficiency. The plurality of heat dissipation fins 150 are arranged on the surface of the substrate 110 at intervals, and the plurality of heat dissipation fins 150 need to occupy a large area of the substrate 110. Because the substrate 110 and the side plate 120 do not occupy a mounting area of the substrate 110 when being fastened, a minimum distance between the heat dissipation fin 150 and the sealing member 140 can be less than the sum of the column width of the heat dissipation fin 150 and the spacing between every two heat dissipation fins 150. This helps fully utilize the mounting area on the substrate 110 and increase a quantity of heat dissipation fins 150, so that an operating temperature of the power assembly 101 can be controlled within an appropriate range. Outermost heat dissipation fins 150 enclose a heat dissipation fin region M (as shown in dashed-line areas in FIG. 6 and FIG. 9). The minimum distance between the heat dissipation fin 150 and the outer peripheral side surface of the substrate 110 is half of a difference between a size value of the substrate 110 and a size value of the heat dissipation fin region M in the length direction B or the width direction C of the substrate 110.

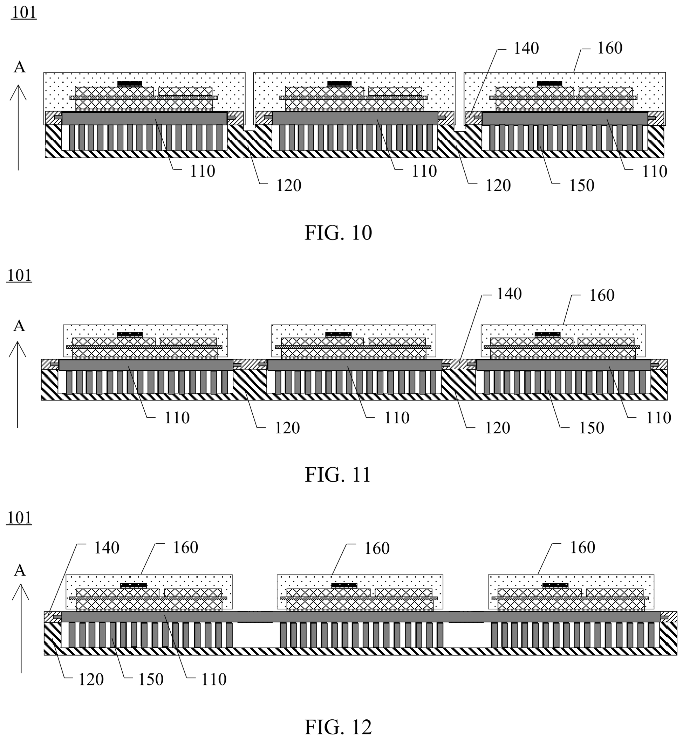

Refer to FIG. 10. FIG. 10 is a diagram of a structure of a power assembly 101 in the motor control unit 100 according to an embodiment of this application. In an embodiment, the power assembly 101 includes a plurality of substrates 110. The plurality of substrates 110 are spaced apart. In an arrangement direction of the plurality of substrates 110, a sealing member 140 between every two adjacent substrates 110 is configured to fasten the two adjacent substrates 110, and is configured to fasten two side plates 120 on one side of the two adjacent substrates 110. In this embodiment of this application, the power assembly 101 includes the plurality of substrates 110, so that a quantity of heat dissipation fins 150 and a quantity of power assemblies that are connected to two sides of the substrate 110 increase. This helps increase an area covered by heat dissipation fins 150, and cooling and heat dissipation can be performed on more power assemblies.

Refer to FIG. 11. FIG. 11 is a diagram of a structure of a power assembly 101 in the motor control unit 100 according to an embodiment of this application. In an embodiment, sealing members 140 between every two adjacent substrates 110 are connected to each other and are jointly configured to fasten two side plates 120 on one side of the two adjacent substrates 110. In an embodiment, the sealing members 140 between every two adjacent substrates 110 are integrally formed through injection molding, thereby improving structural reliability between the two adjacent substrates 110.

Refer to FIG. 12. FIG. 12 is a diagram of a structure of a power assembly 101 in the motor control unit 100 according to an embodiment of this application. In an embodiment, the power assembly 101 includes one substrate 110 and a plurality of power modules 160. The plurality of power modules 160 are spaced apart. A sealing member 140 is connected to a peripheral side surface of the substrate 110 and a surface that is of a side plate 120 and that faces the substrate 110 in a thickness direction A. In this embodiment of this application, the plurality of power modules 160 are fastened on one substrate 110. This simplifies a process and improves production efficiency.

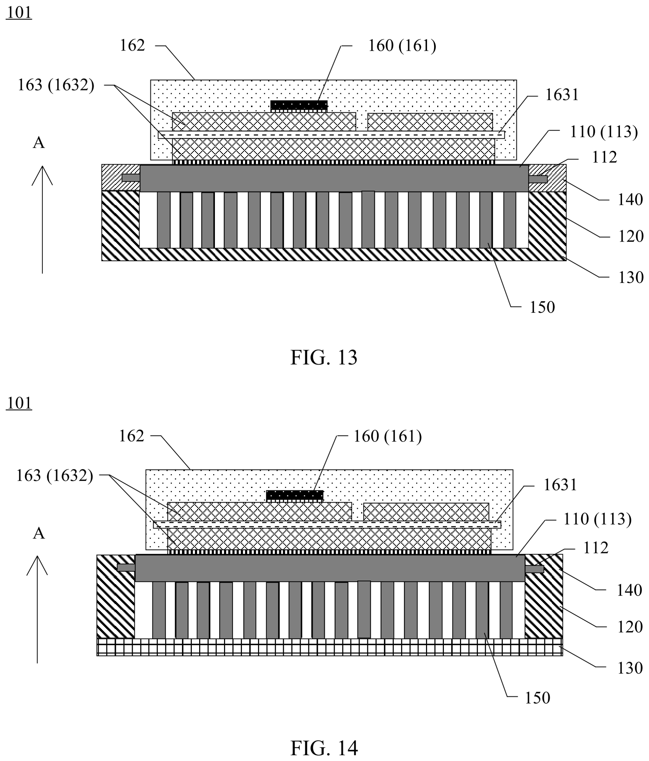

Refer to FIG. 13. FIG. 13 is a diagram of a structure of a power assembly 101 in the motor control unit 100 according to an embodiment of this application. In an embodiment, a bottom plate 130 and a side plate 120 are of an integrated structure. This embodiment of this application helps enhance structural stability of the bottom plate 130 and the side plate 120, thereby improving connection strength between the bottom plate 130 and the substrate 110.

Refer to FIG. 14. FIG. 14 is a diagram of a structure of a power assembly 101 in the motor control unit 100 according to an embodiment of this application. In an embodiment, a sealing member 140 and a side plate 120 are of an integrated structure. This embodiment of this application helps enhance structural stability of the sealing member 140 and the side plate 120, thereby improving connection strength between the side plate 120 and the substrate 110. For example, the sealing member 140 and the side plate 120 may be processed in an integrated manner through laser welding, adhesive bonding, or the like.

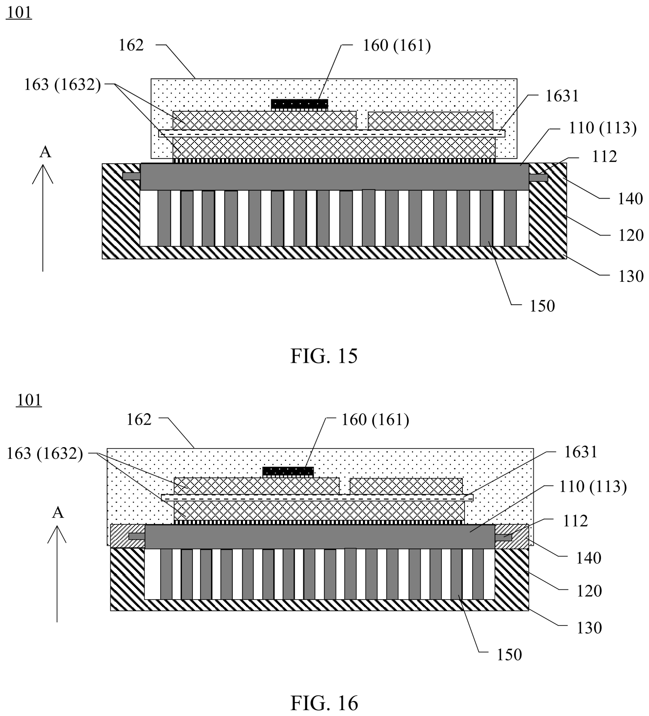

Refer to FIG. 15. FIG. 15 is a diagram of a structure of a power assembly 101 in the motor control unit 100 according to an embodiment of this application. In an embodiment, a sealing member 140, a side plate 120, and a bottom plate 130 are of an integrated structure. The sealing member 140, the side plate 120, and the bottom plate 130 in this embodiment of this application are integrally formed. This helps enhance structural strength of the power assembly 101 and the motor control unit 100.

Refer to FIG. 16. FIG. 16 is a diagram of a structure of a power assembly 101 in the motor control unit 100 according to an embodiment of this application. In an embodiment, the power assembly 101 further includes a packaging structure 162. The packaging structure 162 is configured to package at least one power switching transistor 161, the substrate 110, and the sealing member 140. The other surface of the substrate 110 and a surface that is of the sealing member 140 and that faces away from the power switching transistor 161 are both exposed outside the packaging structure 162.

In this embodiment of this application, the packaging structure 162 and the power switching transistor 161 are fastened on a same side of the substrate 110. The packaging structure 162 can protect the power switching transistor 161 from mechanical damage, chemical corrosion, and damage of another external factor. There is a connection relationship between the packaging structure 162 and the sealing member 140. The other surface of the substrate 110 and the surface that is of the sealing member 140 and that faces away from the power switching transistor 161 are both exposed outside the packaging structure 162. In this way, a projection of the packaging structure 162 in the thickness direction A of the substrate 110 overlaps a projection of the sealing member 140 in the thickness direction A of the substrate 110, and the substrate 110 and the power module 160 are connected and fastened in the thickness direction A. In an embodiment, the substrate 110 is first fastened to the sealing member 140 through nano injection molding, then the substrate 110 is fastened to the power switching transistor 161 through welding or the like, and finally the packaging structure 162 is formed through injection molding, to connect the packaging structure 162 and the sealing member 140, thereby implementing packaging of the substrate 110, the sealing member 140, and the power switching transistor 161 as a whole. Further, before the substrate 110 and the power switching transistor 161 are fastened, the side plate 120 and the bottom plate 130 may be integrally formed on the peripheral side of the substrate 110 through injection molding, and then a subsequent step is performed.

Still refer to FIG. 4. In an embodiment, the packaging structure 162 is not connected to the substrate 110. In the thickness direction A of the substrate 110, a projection of the packaging structure 162 does not overlap a projection of the sealing member 140. In this embodiment of this application, the substrate 110 and the sealing member 140 are first fastened through nano injection molding. The power module 160 pre-packages the power switching transistor 161 by using the packaging structure 162, and finally welds the substrate 110 on which the sealing member 140 is fastened to the power switching transistor 161 on which the packaging structure 162 is fastened. Further, before the substrate 110 is fastened to the power switching transistor 161, the substrate 110 may be first processed and fastened to the side plate 120 and the bottom plate 130, and then a subsequent step is performed.

It should be noted that processes of the substrate and the power module in the power assembly in this embodiment of this application is not limited to the foregoing description, and may be specifically designed according to a requirement.

Still refer to FIG. 16. In an embodiment, the power module 160 further includes a metal-clad substrate 163. The metal-clad substrate 163 includes an insulation substrate 1631 and metal layers 1632 located on two sides of the insulation substrate 1631. The two metal layers 1632 are insulated by using the insulation substrate 1631. The insulation substrate 1631 may be any one of the following: an Al₂O₃ ceramic substrate, an AlN ceramic substrate, and a SiN ceramic substrate. The metal layer 1632 (for example, a copper foil) is directly bonded to the insulation substrate 1631 at a high temperature. In an embodiment, the metal-clad substrate 163 may be a direct bond copper (Direct Bond Copper, DBC) ceramic substrate, an active metal brazing (Active metal brazing , AMB, for example, Al₂O₃-AMB, Si₃N₄-AMB, or AlN-AMB) substrate, an insulated metal substrate (Insulated metal substrate, IMS), or the like.

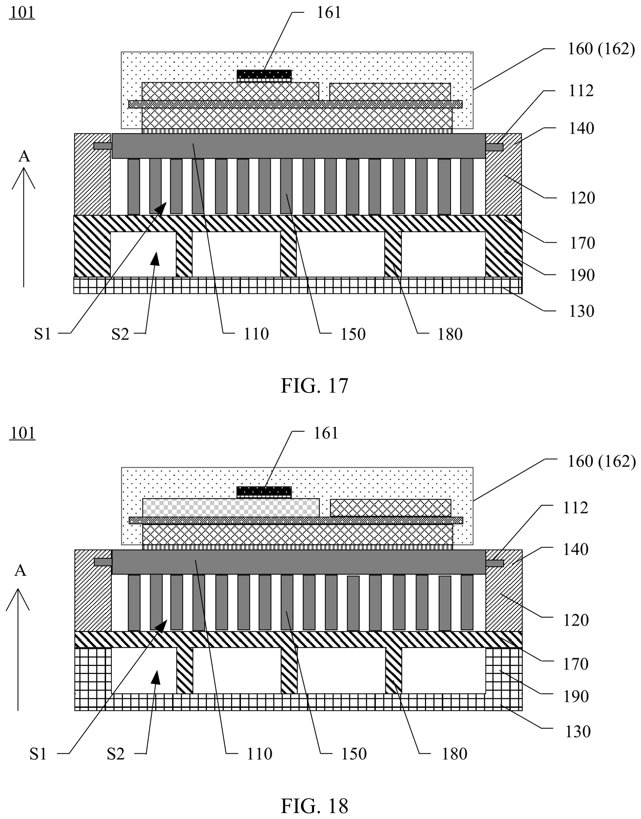

Refer to FIG. 17. FIG. 17 is a diagram of a structure of a power assembly 101 in the motor control unit 100 according to an embodiment of this application. In an embodiment, the power assembly 101 further includes a partition plate 170, a top frame 190, and a plurality of flow dividing columns 180. The partition plate 170, the top frame 190, and the bottom plate 130 enclose a flow dividing cavity S2. The plurality of flow dividing columns 180 are located in the flow dividing cavity S2. The partition plate 170 is integrally formed with the top frame and is fastened to the side plate 120. In the thickness direction A of the substrate 110, two ends of each of the top frame 190 and the flow distribution column 180 are respectively fastened to the bottom plate 130 and the partition plate 170. One end that is of the heat dissipation fin 150 and that faces away from the substrate 110 is fastened to the partition plate 170. The bottom plate 130, the flow distribution column 180, the partition plate 170, the heat dissipation fin 150, and the substrate 110 are sequentially arranged. A distribution density of the flow distribution columns 180 is less than a distribution density of the heat dissipation fins 150. The partition plate 170 and the top frame 190 are made of polymer materials.

In this embodiment of this application, a coolant fed into the power assembly 101 is first dispersed by the flow distribution columns 180, and then flows to space between the plurality of heat dissipation fins 150 in the accommodating cavity S1. The flow distribution columns 180 can distribute the coolant flowing to the heat dissipation fins 150 in advance, to reduce flow resistance. The distribution density of the flow distribution columns 180 is less than the distribution density of the heat dissipation fins 150, so that a loss of the coolant between the flow distribution columns 180 is small. In addition, one end that is of the heat dissipation fin 150 and that is away from the substrate 110 is connected to the partition plate 170. This helps reduce fin top bypass of the heat dissipation fin 150, and improve heat exchange performance of the power assembly 101. Both the partition plate 170 and the top frame 190 are made of the polymer materials. This helps improve connection strength between the partition plate 170 and the top frame 190.

In an embodiment, in embodiments shown in FIG. 10, FIG. 11, and FIG. 12, when the power assembly 101 includes a plurality of substrates 110, the flow distribution cavity S2 and the accommodating cavity S1 are stacked in the thickness direction A, and the coolant is transferred to accommodating cavities S1 on one side of the plurality of substrates 110 through flow distribution cavities S2. The accommodating cavities S1 on one side of the plurality of substrates 110 may be parallel runners or series runners. The flow distribution cavities S2 may be designed based on the parallel runners or the series flow.

Refer to FIG. 18. FIG. 18 is a diagram of a structure of a power assembly 101 in the motor control unit 100 according to an embodiment of this application. In an embodiment, a top frame 190 and a bottom plate 130 are integrally formed. In this embodiment of this application, because the top frame 190 is fastened to a partition plate 170, and a flow distribution column 180 is fastened to the partition plate 170 and the bottom plate 130, the top frame 190 and the bottom plate 130 are integrally formed. This helps improve structural strength of the partition plate 170 and the flow distribution column 180, and ensures that flow distribution columns 180 stably distribute a coolant.

In an embodiment, the power assembly 101 includes two liquid cooling radiators. The two liquid cooling radiators are distributed on two sides of a power switching transistor. A structure of the liquid cooling radiator is the same as a structure of the liquid cooling radiator in the foregoing embodiment.

The motor control unit, the powertrain and the vehicle provided in embodiments of this application are described in detail above. The principles and embodiments in this application are described in this specification by using specific examples. The descriptions about embodiments are merely provided, to help understand the method in this application and core ideas of the method. In addition, a person of ordinary skill in the art can make variations and modifications in terms of the specific embodiments and application scopes according to the ideas of this application. In conclusion, the content of this specification shall not be construed as a limitation to this application.

## Claims

1. A power assembly with a liquid cooling radiator, wherein the power assembly comprises:
a substrate, wherein the substrate is configured to fasten at least one power switching transistor;
the liquid cooling radiator, wherein the liquid cooling radiator comprises a groove structure, the groove structure comprises a bottom plate and a side plate, and the bottom plate and the substrate are spaced apart in a thickness direction of the substrate; and
a sealing member, wherein the sealing member is configured to fasten a peripheral side surface of the substrate and an end face that is of the side plate and that faces away from the bottom plate, and a material of the sealing member is different from a material of the substrate.

2. The power assembly according to claim 1, wherein the bottom plate comprises two through holes spaced apart, each through hole is configured to communicate between two sides that are of the bottom plate and that are in the thickness direction of the substrate, a spacing distance between the two through holes is less than a length of the substrate in an arrangement direction of the two through holes, and hole diameters of the two through holes each are greater than a thickness of the side plate or the bottom plate.

3. The power assembly according to claim 1, wherein the substrate comprises two surfaces, the two surfaces are distributed away from each other in the thickness direction of the substrate, and in the two surfaces,
one surface faces away from the bottom plate, and the surface is configured to fasten the at least one power switching transistor; and
the other surface faces the bottom plate, and the other surface is configured to fasten a plurality of heat dissipation fins.

4. The power assembly according to claim 1, wherein a difference between a melting temperature of a material of the side plate and a melting temperature of the material of the sealing member is less than 50°C, or the material of the sealing member is the same as a material of the side plate.

5. The power assembly according to claim 1, wherein the sealing member is made of a polymer material, and the polymer material is injected on the peripheral side surface of the substrate, to form the sealing member.

6. The power assembly according to claim 1, wherein a material of the side plate is a polymer material, and the polymer material is injected on a surface that is of the sealing member and that faces the bottom plate, to form the side plate.

7. The power assembly according to any one of claims 1 to 6, wherein in a direction perpendicular to the thickness direction of the substrate, a part of one of the substrate and the sealing member is embedded into the other of the substrate and the sealing member.

8. The power assembly according to claim 7, wherein the substrate comprises one of a boss and a groove, the one of the boss and the groove surrounds an outer peripheral side surface of the substrate, the sealing member comprises the other of the boss and the groove, the other of the boss and the groove surrounds an inner peripheral side surface of the sealing member, and a protrusion direction of the boss and a concave direction of the groove are the same and are both perpendicular to the thickness direction of the substrate.

9. The power assembly according to claim 8, wherein a length of the side plate is greater than a length of the boss or the groove in a first direction, the first direction is perpendicular to the thickness direction of the substrate, the length of the side plate in the first direction is greater than a thickness of at least one of the substrate or the bottom plate, and a length of the sealing member in the first direction is greater than a thickness of the substrate.

10. The power assembly according to claim 8, wherein the peripheral side surface of the substrate, a surface of the boss, or a groove wall surface of the groove comprises a nanopore, and the nanopore is configured to accommodate a part of the sealing member.

11. The power assembly according to claim 3, wherein the power assembly further comprises the plurality of heat dissipation fins, and a minimum distance between the heat dissipation fin and an outer peripheral side surface of the substrate is less than a sum of a fin width of the heat dissipation fin and a spacing between every two heat dissipation fins.

12. The power assembly according to claim 3, wherein the power assembly further comprises a packaging structure, the packaging structure is configured to package the at least one power switching transistor, the substrate, and the sealing member, and the other surface of the substrate and a surface that is of the sealing member and that faces away from the power switching transistor are both exposed outside the packaging structure.

13. A motor control unit, wherein the motor control unit comprises a coolant channel and the power assembly according to any one of claims 1 to 12, and the coolant channel communicates with the two through holes in the bottom plate.

14. A powertrain, wherein the powertrain comprises a motor and the motor control unit according to claim 13, and the motor control unit is configured to drive the motor.

15. A vehicle, comprising a vehicle body, a battery pack, and the powertrain according to claim 14, wherein the battery pack and the powertrain are mounted on the vehicle body, and a power module in the motor control unit is configured to: convert, into an alternating current, a direct current output by the battery pack, and provide the alternating current for the motor to drive the vehicle to travel.
